# EUROPEAN PATENT APPLICATION

(11) **EP 4 475 166 A1**
(43) Date of publication of application: **11.12.2024**
(21) Application number: 24179025.2
(22) Date of filing: 30.05.2024
(51) Int. Cl.: H01L 21/48, H01L 23/31, H01L 23/495

(54) **PACKAGED SEMICONDUCTOR DEVICE AND METHOD OF MANUFACTURING**

(30) Priority: 09.06.2023 CN 202310678533
(71) Applicant: NXP USA, Inc., Austin TX 78735 (US)
(72) Inventor: Ge, You, 5656AG Eindhoven (NL); Wang, Zhijie, 5656AG Eindhoven (NL); Lee, Yit Meng, 5656AG Eindhoven (NL)
(74) Representative: Hardingham, Christopher Mark

(57) **Abstract**

A packaged semiconductor device has a first surface, a second surface opposite the first surface, and sidewalls therebetween. The semiconductor device includes: a device die arranged in a central region surrounded by the sidewalls; a plurality of electrically conductive contacts around a peripheral region of the second surface; and molding compound between electrically conductive contacts, and between the device die and the electrically conductive contacts. The electrically conductive contacts each have an end side surface forming a part of the sidewall, and remainder of the sidewall comprises surfaces of the molding compound. The packaged semiconductor device has recesses between the electrically conductive contacts, each recess has a first distance along the sidewall from the second surface towards the first surface, and a second distance from the sidewall towards the central region.

## Description

### BACKGROUND

The present disclosure relates to a packaged semiconductor device and a method of manufacturing the packaged semiconductor device.

Leadless packaged semiconductor devices, such as quad flat no lead ("QFN") packaged devices, provide challenges as regards reliably connecting the packaged devices with others, such as printed circuit boards ("PCB"). A leadless packaged semiconductor device is mechanically and electrically connected to a PCB through a solder joint between soldering pads respectively on the device and the PCB. The connection is vulnerable as the solder joint of this kind can easily become void, fail, or crack.

### SUMMARY

This summary is provided to introduce a selection of concepts in a simplified form that are further described below in the Detailed Description. This summary is not intended to identify key or essential features of the claimed subject matter, nor is it intended to be used to limit the scope of the claimed subject matter.

In one embodiment, a packaged semiconductor device has a first surface, a second surface opposite the first surface, and sidewalls therebetween. The semiconductor device includes: a device die arranged in a central region surrounded by the sidewalls; a plurality of electrically conductive contacts around a peripheral region of the second surface; and molding compound between electrically conductive contacts, and between the device die and the electrically conductive contacts. The electrically conductive contacts each have an end side surface forming a part of the sidewall, and remainder of the sidewall comprises surfaces of the molding compound. The packaged semiconductor device has recesses between the electrically conductive contacts, each recess has a first distance along the sidewall from the second surface towards the first surface, and a second distance from the sidewall towards the central region.

In another embodiment, a method of manufacturing a packaged semiconductor device includes: providing an array of lead-frames comprising at least two lead-frames and a connection bar therebetween, wherein each lead-frame is connected to a respective side of the connection bar, wherein each lead-frame comprises a plurality of electrically conductive contacts connected to and along the side of the connection bar to which said lead-frame is connected, and wherein the connection bar further comprises outer parts between and connecting outermost end parts of the electrically conductive contacts, the outer parts have first recesses between adjacent electrically conductive contacts, such that a first thickness of the outer part is less than a full thickness of the lead-frame; disposing molding compound in the first recesses from a first side-face of the connection bar; removing a remainder part of the outer parts having the first thickness from the second side-face of the connection bar opposite the first side-face, such that the outer parts have second recesses on the second side-face; and separating the connection bar from the electrically conductive contacts to produce the packaged semiconductor device, the packaged semiconductor device has the second recesses between the electrically conductive contacts.

In one or more embodiments, each electrically conductive contact comprises an innermost end region close to a central region of the lead-frame, and has a first side-face and an opposite second side-face; and wherein the electrically conductive contact has a third recess at the innermost end region, the third recess receives the molding compound.

In one or more such embodiments, providing the array of lead-frames comprises etching a second side-face of the innermost end of the electrically conductive contact to provide the third recess, the second side-face of the innermost end of the electrically conductive contact is coplanar with the second side-face of the connection bar.

In one or more such embodiments, the method further comprises encapsulating a respective device die assembled to a one of the array of lead-frames with the molding compound, including disposing the molding compound in the third recess.

In one or more embodiments, the second recesses expose a part of a side-face of the electrically conductive contacts.

In one or more embodiments, the method further comprises plating the part of the side-face of the electrically conductive contacts exposing by the second recesses.

### BRIEF DESCRIPTION OF THE DRAWINGS

So that the manner in which the above recited features of the present disclosure can be understood in detail, a more detailed description of the disclosure may be had by reference to embodiments, some of which are illustrated in the appended drawings. The appended drawings illustrate only typical embodiments of the disclosure and should not limit the scope of the disclosure, as the disclosure may have other equally effective embodiments. The drawings are for facilitating an understanding of the disclosure and thus are not necessarily drawn to scale. Advantages of the subject matter claimed will become apparent to those skilled in the art upon reading this description in conjunction with the accompanying drawings, in which like reference numerals have been used to designate like elements, and in which:
FIG. 1 is a perspective view of a semiconductor device of an embodiment;
FIG. 2 is a bottom side view of a semiconductor device of an embodiment;
FIG. 3 is a flow diagram of a method of manufacturing a semiconductor device according to an embodiment;
FIG. 4 is a top view of an array of lead-frames according to an embodiment.
FIG. 5 is an enlarged top view of a lead-frame of FIG. 4 and a cross-sectional view along B-B and C-C;
FIG. 6 is a cross-sectional view of the connection bar after the molding compound is disposed;
FIG. 7 is a cross-sectional view of the connection bar after removing the remaining part of the connection bar;
FIG. 8A illustrates a bottom view of an assembly of the array of lead-frame and the molding compound with etching a second surface of the connection bar according to an embodiment;
FIG. 8B illustrates a bottom view of an assembly of the array of lead-frame and the molding compound with etching or sawing a second surface of the connection bar according to another embodiment;
FIG. 9 is a cross-sectional view of the semiconductor device when in connection with a system board through soldering; and
FIG. 10 is a cross-sectional view along A-A of FIG. 2 according to an embodiment.

### DETAILED DESCRIPTION

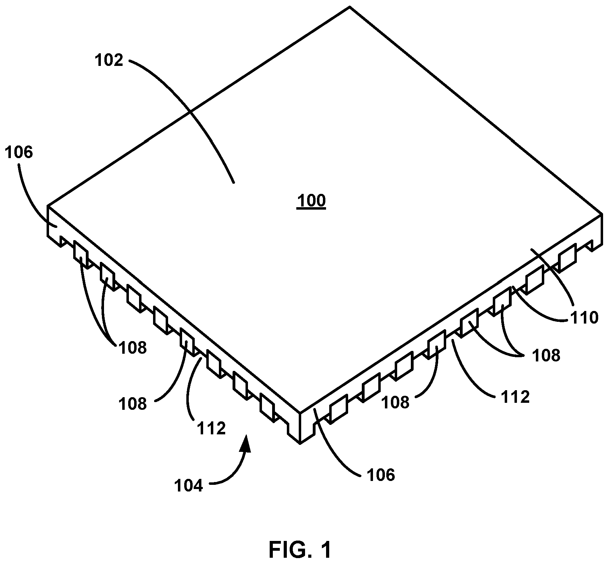

FIG. 1 is a perspective view of a semiconductor device of an embodiment. The semiconductor device 100 has a first surface 102 which is also a top surface when viewing from a top side of FIG. 1, and an opposite second surface 104 which is also a bottom surface. The semiconductor device 100 has four sidewalls, or side surfaces, 106 that surrounds a main body of the semiconductor device 100 between the first surface 102 and the second surface 104. Inside the semiconductor device 100 there includes a device die (not shown in FIG. 1) in a central region surrounded by the sidewalls 106.

On the second surface 104 of the semiconductor device 100, there includes multiple electrically conductive contacts 108 around peripheral region of the second surface 104, and the electrically conductive contacts 108 are also exposed on a corresponding sidewall 106. The electrically conductive contacts108 are formed of one or more conductive materials such as copper, and are preferably plated, and are for providing electrical connections between the semiconductor device 100 and external devices or circuits. The semiconductor device 100 also includes molding compound 110 that exposes on the first surface 102. The molding compound 110 forms and thereby defines the first surface 102, the second surface 104, and the sidewalls 106. On the sidewall 106, the molding compound 110 are arranged between the electrically conductive contacts 108, and alternates with the electrically conductive contacts 108. It can also be understood that inside the semiconductor device 100 the molding compound 110 is between the device die and the electrically conductive contact 108. At locations where the second surface 104 and the sidewall 106 join or meet, and between the adjacent electrically conductive contacts 108, the molding compound 110 has recesses, or recessions, 112.

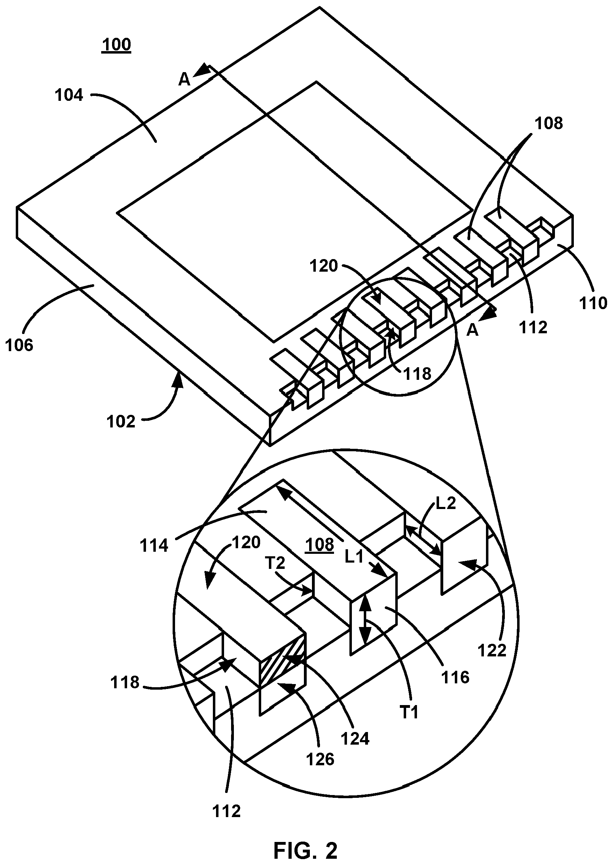

FIG. 2 is a bottom-up view of the semiconductor device 100 of FIG. 1 according to the embodiment. For ease of description, FIG. 2 shows the electrically conductive contacts 108 and the recesses 112 in the molding compound 110 on only one edge of the second surface 104. However, it should be understood that the electrically conductive contacts 108 and the recesses 112 are configured on the other edges of the second surface 104. Each electrically conductive contact 108 has an internal end 114 extending towards central the semiconductor device 100, and an opposing external end 116 which also is exposed on the sidewall 106 and forms a part of the corresponding sidewall 106, while the remainder of the sidewall 106 includes surfaces of the molding compound 110. The electrically conductive contact 108 has a side-face 118 and a bottom surface 120. Part of the side-face 118 is exposed in the recess 112 which also may be referred to a notch. The bottom surface 120 exposes on the second surface 104 of the semiconductor device 100. According to the embodiment, the part of the side-face 118 that is exposed in the recess 112 and the bottom surface 120 of the electrically conductive contact 108 are plated.

The external end 116 of the electrically conductive contact 108 has an end side surface 122 exposed on the sidewall 106, and forms a part of the sidewall 106. The remainder of the sidewall 106 includes surfaces of molding compound 110. Half, or approximately half, the end side surface 122 of the electrically conductive contact 108 that joins the bottom surface 120 is plated, as depicted by the shadings 124 in FIG. 2, and the other half 126 of the end side surface 122 is not plated. Also for ease of description, plating is illustrated on only one end side surface 122, it shall be understood that the other electrically conductive contacts 108 can be configured to have the similar plating on the half of the end side surfaces 122 that join the bottom surface 120.

The electrically conductive contact 108 has a distance, or a thickness, T1, measured along a direction on the end side surface 122 or the sidewall 106 from the second surface 104 to the first surface 102. The recess 112 has a distance, or a depth, T2, measured also along a direction on the sidewall 106 from the second surface 104 to the first surface 102. In the embodiment, the recess 112 is recessed from the second surface 104 by between 40% to 60% of, and typically around half, the thickness of the electrically conductive contact 108, which is to say, the depth T2 is between 40% to 60% of, and typically around half, the thickness T1. The electrically conductive contact 108 has a distance, or length, L1, measured from the internal end 114 to the external end 116 on the second surface 104, or from the sidewall 106 towards the central region. The recess 112 in the molding compound 110 has a distance, or length, L2, measured along a direction from the sidewall 106 to innermost the recess 112. The length L2 is 1/3 the length L1 in this embodiment, which means the recess 112 is recessed from the sidewall 106 to a size 1/3 of the length of the electrically conductive contact 108. In an alternative embodiment, the length L2 of the recess 112 can have another ratio relative to the length L1 of the electrically conductive contact 108, for example between 25% and 50%, etc.

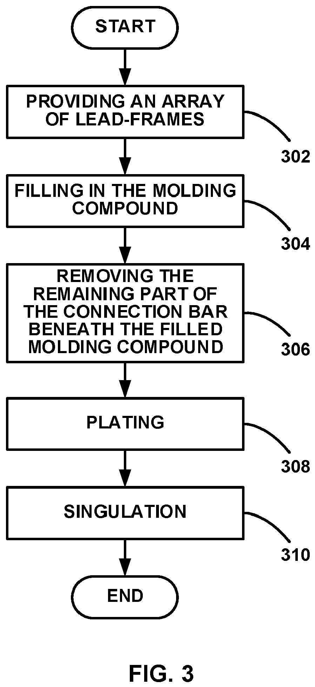

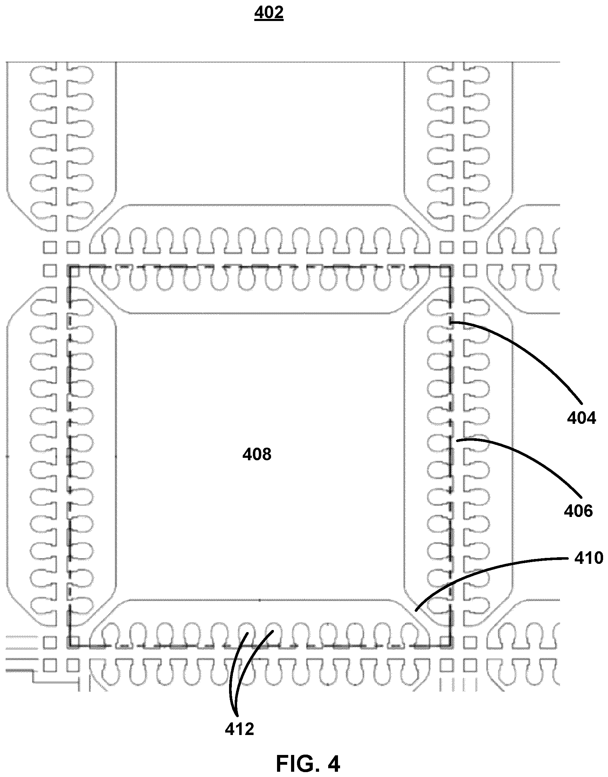

FIG. 3 is a flow diagram of a method of manufacturing a packaged semiconductor device according to an embodiment. The method can be implemented in the manufacture of the packaged semiconductor device 100 of FIG. 1 and FIG. 2, and will be described with reference thereto, in combination with references to FIG. 4 to FIG. 8.

The method starts with step 302 in which an array of lead-frames are provided. It can be understood that an array of lead-frames include multiple lead-frames that are, preferably, separately in another process, manufactured typically by stamping a pieces of metal material, for example copper strip material. FIG. 4 depicts part of an array 402 of lead-frames which includes multiple units of lead-frames 404 that are arranged to be aligned horizontally and vertically to form the array 402. The array 402 includes connection bars 406 between lead-frames 404. The connection bar 406 connects neighboring lead-frames 404 together, such that the array 402 is an integral assembly of the discrete elements in the lead-frames 404. For example, a connection bar 406 connects to two lead-frames 404 at each side thereof, and a lead-frame 404 has four edges each connecting to a side of a respective connection bar 406.

Also referring to FIG. 4, the lead-frame 404 includes a die flag 408 which is in a central region and connected to the connection bar 406 through four die-flag connection bars 410 at the four corners. Connected to the side of connection bar 406, each lead-frame 404 includes a plurality of electrically conductive contacts 412 along that side of the connection bar 406. The electrically conductive contacts 412 are separate from and spaced apart from the die flag 408. The lead-frame 404 is typically made from metal materials, for example copper, with a thickness of between 0.1 and 0.3 millimeters.

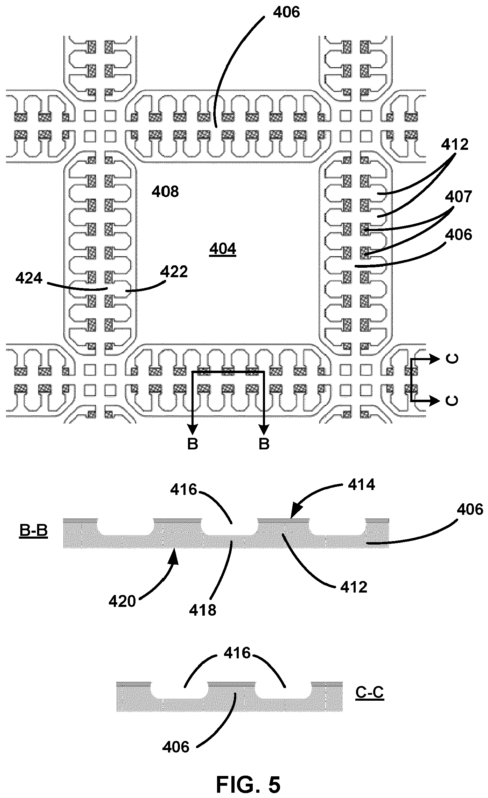

FIG. 5 is an enlarged view of a lead-frame 404 of the array 402 (together with parts of four neighboring lead-frames) of FIG. 4, in plan view, and a partial cross-section B-B along the connection bar 406, and a cross-section C-C of the connection bar 406. Outer parts 407 (that is to say, the parts that are closer to the die flag 408) of the connection bar 406 have a reduced thickness resulting from first half-depth recesses 416, at locations between adjacent electrically conductive contacts 412. A central part of the connection bar 406 has full thickness. Viewed from the B-B cross-sectional perspective, the first half-depth recesses, or notches, 416, are formed by etching a first surface, which is a top surface, 414 of the connection bar 406 at the locations between the adjacent electrically conductive contacts 412, to a depth around half a thickness of the connection bar 406 and leaving a remaining part 418 connecting the adjacent electrically conductive contacts 412. A layer on the first surface 414 with darker color shows that the array 402 is plated, which plating is optional in alternative embodiments. Plated material may also be provided with the lead-frame on the bottom surface 420. Plated materials include silver, nickel, or tin-lead, etc., with a thickness of several microns, typically between 3 and 20 microns. The remaining part 418, thus still extends on a second surface, which is a bottom surface, 420 of the connection bar 406 opposite the first surface 414. The second surface 420 of the connection bar 406 is typically coplanar with a bottom surface of the die flag 408 and a bottom surface of the electrically conductive contact 412.

The first half-depth recess 416 can be formed either in the process of manufacturing the array 402 of lead-frames, or in the process of FIG. 3 of manufacturing the semiconductor device, such as in step 302 of the method. As described above, the thickness of the lead-frame 404 is between 0.1 and 0.3 millimeters, half-etching the first half-depth recess 416 can be implemented to a depth of between 0.05 and 0.15 millimeters, and may be even deeper to 0.2mm.

With reference to FIG. 1 and FIG. 2, the electrically conductive contacts 412 each include an internal end 422 extending away from the central part of the connection bar 406 but towards the die flag 408, and an external end 424 opposite the internal end 422, the external end 424 is adjacent the outer part 407 of the connection bar 406. The electrically conductive contact 412 has a length L1 measured from the internal end 422 to the external end 424, and the first half-depth recess 416 has a length L2 measured along a direction from the connection bar 406 towards the die flag 408. The length L2 is 1/3 the length L1 in this embodiment. The ratio of the length L2 relative to the length L1 can be 1/2, 1/4, etc., and is typically within a range between 1/4 and 3/4.

The method of manufacturing the semiconductor device follows with step 304 in which the first half-depth recess 416 of the connection bar 406 is filled with molding compound. Step 304 typically follows a step of attaching a semiconductor device die (not shown) to the die flag 408 of the lead-frame 404, and connecting the semiconductor device die to the electrically conductive contacts 412 by wire bonding or other applicable techniques. The molding compound is disposed on the top surface 414 of the connection bar 406, and also on a top surface of the electrically conductive contact 412. Generally, the molding compound also encapsulates the semiconductor device die on a top surface of the die flag 408 and the bonding wire, and fills in the space between the die flag 408 and the electrically conductive contacts 412. Typically, the molding compound is introduced into a mold frame, and fills the mold frame thereby defining, for example, the top, or first, surface 102 of the packaged semiconductor device 100. After curing the molding compound, the discrete elements of the lead-frame 404, the semiconductor device die, and the bonding wires are rigidly integrated, the second surface 420 of the connection bar 406 opposite the first surface 414, and the bottom surfaces of the electrically conductive contact 412 and the die flag 408, are exposed on the second surface 104 of the semiconductor device 100, to provide external connection to/from the semiconductor device.

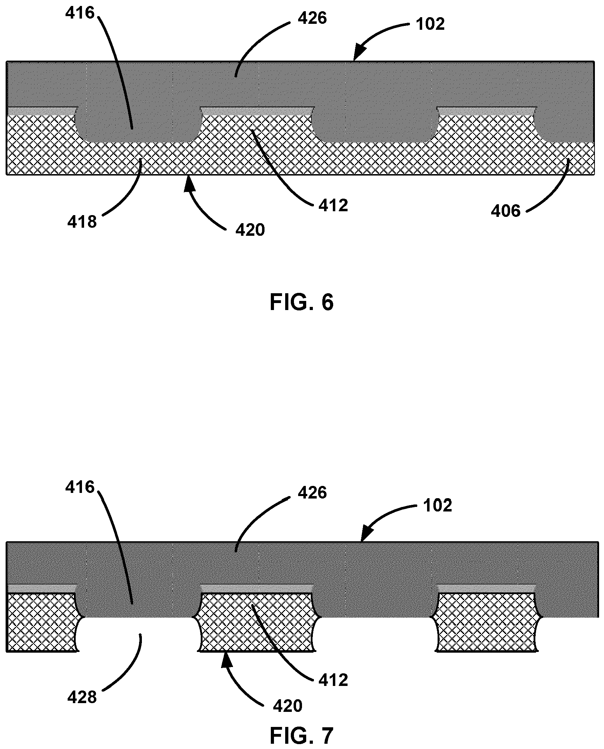

FIG. 6 is a cross-sectional view along the outer part of the connection bar after the molding compound is disposed. After the molding process, the second, or bottom, surface 420 of the connection bar 406 remains exposed without being covered by the molding compound 426. As the first half-depth recess 416 is from the first, or top, surface 414 of the connection bar 406, the molding compound 426 also flows into and fills the first half-depth recess 416.

At step 306 of the method of FIG. 3, a part of the connection bar 406, which is beneath the molding compound 426 filling the first half-depth recess 416, is removed. Specifically, the remaining part 418, after the first half-depth recess 416 is etched, is now removed. FIG. 7 depicts a cross-sectional view of the connection bar after the removal. The figure shows a second half-depth recess or notch 428, which results from the removal. With the remaining part 418 of the outer part 407 of the connection bar 406 beneath the filled molding compound in the first half-depth recess 416 being removed, the outer part 407 of the connection bar 406, between the electrically conductive contacts 412, is now completely absent. The removal of the remaining part 418 can be implemented through another half-etching process from the second surface 420 on the connection bar 406 at positions corresponding to and in alignment with the first half-depth recess 416, until the filled molding compound 426 in the first half-depth recess 416 is exposed. As described before, the first half-depth recess 416 is formed by etching the connection bar 406 to a depth typically of about half the thickness of the connection bar 406. The removal of the remaining part 418 shall now be implemented by etching away the remaining half the thickness of the connection bar 406, such that the second half-depth recess 428 also typically have a depth of about half the thickness of the connection bar 406 or the electrically conductive contact 412. In other words, the second half-depth recess 428 is recessed from the second surface 420 for typically about half the thickness of the connection bar 406. The skilled person will appreciate that, in embodiments in which the first half-depth recess 416 has a depth of 1/4 the thickness of the connection bar 406, the second half-depth recess 428 will have a depth of about 3/4 the thickness of the connection bar 406.

As described above, the first half-depth recess 416 is etched to have a length L2 which is preferably 1/3 of the length L1 of the electrically conductive contact 412. The removal of the remaining part 418 by etching is typically implemented such that length of the second half-depth recess 428 is the same as that of the first half-depth recess 416. In other words, a length of the second half-depth recess 428 typically equals the length of the first half-depth recess 416, which is also 1/3 of length L1 of the electrically conductive contact 412 between the internal end 422 and the external end 424.

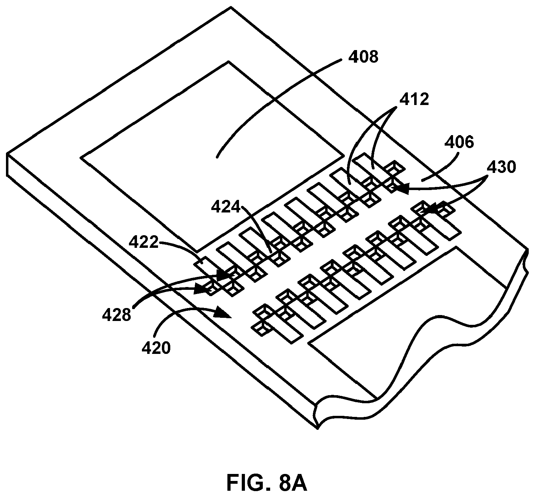

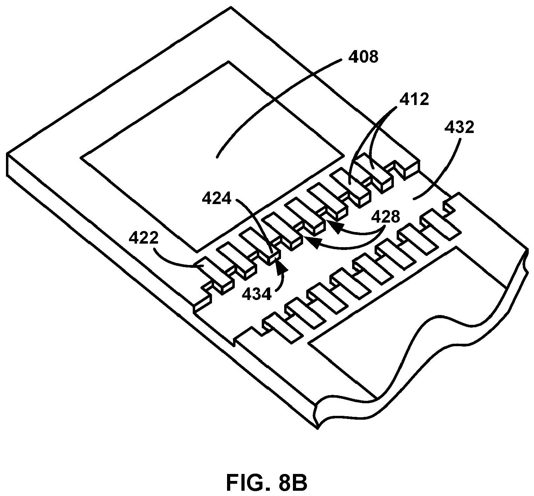

Referring to FIG. 8A and FIG. 8B, the method further includes, before the optional step 308 of plating the second half-depth recess 428, a step of exposing part of an end side surface of the external end 424, which is similar to the end side surface 122 of FIG. 2. This step of exposing part of the end side surface of the external end 424 may typically be implemented by etching a second surface 420 of the part of the connection bar 406 that connects to the external end 424. As illustrated in FIG. 8A, for exposing the part of the end side surface of the external end 424, the second surface 420 of the connection bar 406 may be etched at locations only beside the external end 424. This step of etching the connection bar 406 at locations beside the external end 424 can be implemented together with step 306 of etching the connection bar 406, by etching on the second surface 420 at locations align with the first half-depth recess 416, and also to a depth of half the thickness of the connection bar 406. The etching removes the part of the connection bar 406 at locations beside the external end 424 of the electrically conductive contact 412, thus forms recesses 430 next to the external end 424 of the electrically conductive contact 412, and exposing part of an end side surface of the external end 424, similar to the end side surface 122 of FIG. 2.

Referring further to FIG. 8B, according to an alternative embodiment, for exposing part of the end side surface of the external end 424, the second surface 420 of the connection bar 406 may be etched or sawn along the whole connection bar 406. The connection bar 406 is etched to a depth of half its thickness, and forms a slot 432 outside the edge of the lead-frame 404 in the connection bar 406, also exposing a part 434 of the end side surface of the external end 424. The sawing step can be implemented to a depth from the second surface 420 sufficient to expose the end side surface but not separating the molded semiconductor devices before the optional plating step 308. The sawing step can also be implemented as a singulation step as will be described below. The recesses 430 of FIG. 8A or the slot 432 of FIG. 8B allow a subsequent and optional step 308 of plating to plate the part 434 of the end side surface of the electrically conductive contact 412. As can be understood, because either the etching or the sawing the connection bar 406 to expose the part 434 of the end side surface are implemented to a depth of half the thickness of the connection bar 406, the resulting exposed part 434 of the end side surface typically has a height of half the thickness of the connection bar 406, as can be illustrated more clearly with reference to 124 and 126 of FIG. 2.

The method of FIG. 3 includes, after step 306, an optional step 308 to plate the second half-depth recess 428, the bottom surface of the electrically conductive contact 412, and the bottom surface of the die flag 408 that are exposed on the second, bottom, surface of the semiconductor device. The optional step 308 of plating can be implemented by plating matte Tin (Sn) or any other material that improves the joint of the leads of the semiconductor device 100 with the solder in future soldering process. The plating may help to provide better connection with solder when the semiconductor device manufactured is mounted to a system board, such as a printed circuit board or similar. It shall be understood that by this option step 308, the manufactured article resulting after molding compound is disposed on the array 402 of the lead-frames 404 and the connection bars 406, is not singulated, the connection bars 406 still connect the neighboring lead-frames 404 together. The step 308 also plates the exposed part 434 of the end side surface of the external end 424 of the electrically conductive contact 412, resulting in this half the end side surface being plated. Similar to the above described plating materials, the step 308 plates silver, nickel, tin-lead, or other applicable materials, to a thickness of between 3 and 20 microns.

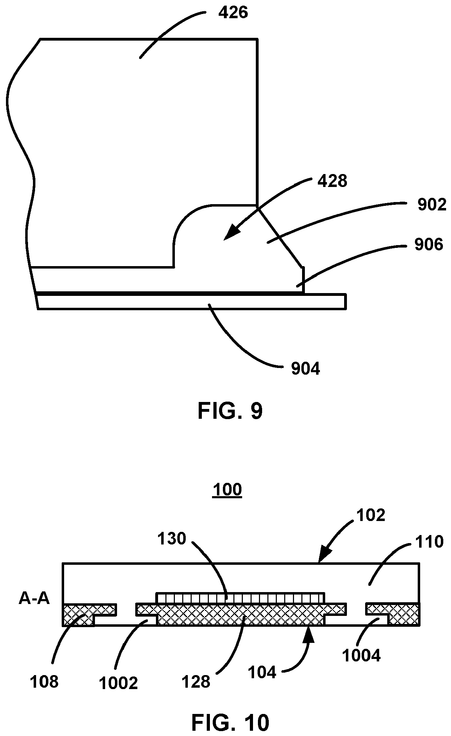

With reference to FIG. 9, which is a cross-sectional view of part of the semiconductor device of FIG. 8 when in connection with a system board through soldering, also viewing from the C-C section line of FIG. 5, the plating on the end side surface of the electrically conductive contact 412 allows solder 902 to creep up to a height up to half the thickness of the electrically conductive contact 412 when the packaged semiconductor device is mounted onto a system board 904. As the creeping solder 902 have supports from the solder base 906 on the system board 904 which is larger in size, taking a top view, the solder base 906 can be seen to exceed the footprint of the semiconductor device, allowing the soldering between the semiconductor device and the system board 904 to be inspected through AOI (automated optical inspection) mechanisms. As can also be understand from FIG. 9, the second half-depth recess 428 receives enough solder and firmly joints the electrically conductive contact 412 with the system board 904, enhancing both mechanical and electrical connections of the semiconductor device.

Step 310 is a singulation step after semiconductor device dies are placed and connected, and molding compound is disposed. Step 310 of singulation separates the connection bar 406 from the electrically conductive contacts 412, leaving the second half-depth recesses 428 and the filled molding compound 426 above the second half-depth recesses 428 integral with the electrically conductive contacts 412 in the semiconductor device, as shown in FIG. 1 and FIG. 2. The singulation step 310 can be implemented through sawing the packaged assembly along the connection bar 406, until the neighboring semiconductor devices are fully separated.

FIG. 10 is a cross-sectional view of the semiconductor device 100 along A-A of FIG. 2 according to an embodiment. The lead-frame for the semiconductor device 100, according to this embodiment, is provided such that locking recesses 1002 are configured in perimeter regions along the edges of the die flag 128 on the second surface 104. The die flag 128 holds a device die 130 which is assembled onto the lead frame. Similar locking recesses 1004 may also be configured at the innermost end region of the electrically conductive contact 108 on the second surface 104. The locking recesses 1002 and 1004 allow the molding compound 110 to flow in and fill, either in a separate molding step or together with the molding step 304 of FIG. 3. Similar to the second half-depth recess 428, the locking recesses 1002 and 1004 can be formed through etching either in a separate lead-frame manufacturing process or in the semiconductor device manufacturing process before the molding compound is filled in. The etching starts from the bottom surface of the die flag 128 and/or the internal end of the electrically conductive contact 108, until a depth of half the thickness of the lead-frame, which means the locking recesses 1002 and 1004 is recessed from the second surface 104 by half the thickness of the electrically conductive contact 108. The locking recesses 1002 and 1004 offers a wider opening on the second surface 104, and the unetched parts of the die flag 128 and the electrically conductive contact 108 form a bottleneck, such that the molding compound 110 filled in the wider opening act as a lock to tightly contact the lead-frame with the molding compound 110, and avoids delamination or cracking.

The use of the terms "a" and "an" and "the" and similar referents in the context of describing the subject matter (particularly in the context of the following claims) are to be construed to cover both the singular and the plural, unless otherwise indicated herein or clearly contradicted by context. The terms "coupled" and "connected" both mean that there is an electrical connection between the elements being coupled or connected, and neither implies that there are no intervening elements. In describing transistors and connections thereto, the terms gate, drain and source are used interchangeably with the terms "gate terminal", "drain terminal" and "source terminal". Recitation of ranges of values herein are intended merely to serve as a shorthand method of referring individually to each separate value falling within the range, unless otherwise indicated herein, and each separate value is incorporated into the specification as if it were individually recited herein. Furthermore, the foregoing description is for the purpose of illustration only, and not for the purpose of limitation, as the scope of protection sought is defined by the claims set forth hereinafter together with any equivalents thereof entitled to. The use of any and all examples, or exemplary language (e.g., "such as") provided herein, is intended merely to better illustrate the subject matter and does not pose a limitation on the scope of the subject matter unless otherwise claimed. The use of the term "based on" and other like phrases indicating a condition for bringing about a result, both in the claims and in the written description, is not intended to foreclose any other conditions that bring about that result. No language in the specification should be construed as indicating any non-claimed element as essential to the practice of the disclosure as claimed.

Preferred embodiments are described herein, including the best mode known to the inventor for carrying out the claimed subject matter. Of course, variations of those preferred embodiments will become apparent to those of ordinary skill in the art upon reading the foregoing description. The inventor expects skilled artisans to employ such variations as appropriate, and the inventor intends for the claimed subject matter to be practiced otherwise than as specifically described herein. Accordingly, this claimed subject matter includes all modifications and equivalents of the subject matter recited in the claims appended hereto as permitted by applicable law. Moreover, any combination of the above-described elements in all possible variations thereof is encompassed unless otherwise indicated herein or otherwise clearly contradicted by context.

## Claims

1. A packaged semiconductor device having a first surface, a second surface opposite the first surface, and sidewalls therebetween, wherein the semiconductor device comprising:
a device die arranged in a central region surrounded by the sidewalls;
a plurality of electrically conductive contacts around a peripheral region of the second surface; and
molding compound between electrically conductive contacts, and between the device die and the electrically conductive contacts;
wherein the electrically conductive contacts each have an end side surface forming a part of the sidewall, and remainder of the sidewall comprises surfaces of the molding compound; and
wherein the packaged semiconductor device has recesses between the electrically conductive contacts, each recess has a first distance along the sidewall from the second surface towards the first surface, and a second distance from the sidewall towards the central region.

2. The packaged semiconductor device of claim 1, wherein the recesses expose a part of a side-face of the electrically conductive contacts.

3. The packaged semiconductor device of claim 1 or 2, wherein the molding compound is exposed on the first surface of the packaged semiconductor device.

4. The packaged semiconductor device of any preceding claim, wherein electrically conductive contacts extend a third distance from the sidewalls towards the central region, and the second distance is between 25% and 50% of the third distance.

5. The packaged semiconductor device of any preceding claim, wherein the electrically conductive contacts extend a fourth distance along the sidewalls from the second surface towards the first surface, and the first distance is between 40% and 60% of the fourth distance.

6. The packaged semiconductor device of any preceding claim, wherein the device die is arranged on a die flag in the central region, and wherein at least one of a perimeter region of the die flag and an innermost end region of the electrically conductive contacts is recessed from the second surface, and wherein the recesses region from the second surface comprises the molding compound.

7. The packaged semiconductor device of any preceding claim, wherein the electrically conductive contacts each comprise a plated material at the second surface.

8. The packaged semiconductor device of any preceding claim, wherein the end side surfaces of the electrically conductive contacts each comprise a plated material.

9. The packaged semiconductor device of claim 8, wherein the exposed side-face of the electrically conductive contacts, and a part of the end side surface, each comprise a plated material.

10. The packaged semiconductor device of any preceding claim, wherein the first distance is between 0.05 and 0.13 millimeters.

11. A method of manufacturing a packaged semiconductor device comprising:
providing an array of lead-frames comprising at least two lead-frames and a connection bar therebetween, wherein each lead-frame is connected to a respective side of the connection bar, wherein each lead-frame comprises a plurality of electrically conductive contacts connected to and along the side of the connection bar to which said lead-frame is connected, and wherein the connection bar further comprises outer parts between and connecting outermost end parts of the electrically conductive contacts, the outer parts having first recesses between adjacent electrically conductive contacts, such that a first thickness of the outer part is less than a full thickness of the lead-frame;
disposing molding compound in the first recesses from a first side-face of the connection bar;
removing a remainder part of the outer parts having the first thickness from the second side-face of the connection bar opposite the first side-face, such that the outer parts have second recesses on the second side-face; and
separating the connection bar from the electrically conductive contacts to produce the packaged semiconductor device, the packaged semiconductor device has the second recesses between the electrically conductive contacts.

12. The method of claim 11, wherein providing the array of lead-frames comprises etching the outer parts of the connection bar on the first side-face at locations between the adjacent electrically conductive contacts to provide the connection bar with the first recesses.

13. The method of claim 12, wherein etching the outer parts of the connection bar on the first side-face comprising etching outer parts of the connection bar from the first side-face until a distance between 40% and 60% of the full thickness of the lead-frame.

14. The method of any of claims 11 to 13, further comprising encapsulating a device die assembled to the array of lead-frames with the molding compound, including disposing molding compound in the first recesses from the first side-face of the connection bar, and exposing the second side-face of the electrically conductive contacts opposite the first side-face.

15. The method of any of claims 11 to 14, wherein removing the remainder part of the outer parts comprise etching the outer parts on the second side-face until the molding compound in the first recess.
